(19) Europäisches Patentamt
European Patent Office
Office européen des brevets

(11) Veröffentlichungsnummer: **0 515 793 A2**

(12) # EUROPÄISCHE PATENTANMELDUNG

(21) Anmeldenummer: **92105256.9**

(22) Anmeldetag: **27.03.92**

(30) Priorität: **29.05.91 DE 4117573**

(43) Veröffentlichungstag der Anmeldung:
**02.12.92 Patentblatt 92/49**

(84) Benannte Vertragsstaaten:
**AT BE CH DE DK ES FR GB GR IT LI LU NL SE**

(51) Int. Cl.⁵: **G01R 29/10**, G01S 7/40

(71) Anmelder: **Messerschmitt-Bölkow-Blohm GmbH**
**Robert-Koch-Strasse**
**W-8012 Ottobrunn(DE)**

(72) Erfinder: **Heidrich, Eberhardt**
**Berliner Strasse 25**
**W-7500 Karlsruhe 21(DE)**
Erfinder: **Steiner, Hans-Jürgen**
**Alte Poststrasse 74**
**W-8011 Baldham(DE)**
Erfinder: **Wiesbeck, Werner, Prof. Dr.**
**Ettlinger Strasse 36**
**W-7538 Keltern/Ellmendingen(DE)**
Erfinder: **Riegger, Sebastian, Dr.-Ing.**
**Mozartstrasse 40**
**W-7991 Eriskirch-Schlatt(DE)**

(54) **Verfahren zum Kalibrieren von Radar- und Antennenanordnungen.**

(57) Polarimetrische Messungen des Radarquerschnittes erfordern die Bestimmung von zwölf Fehler- oder Korrekturkoeffizienten für die Kalibrierung einer Meßanordnung in Phase und Amplitude. Hierzu wird zunächst ein einziges Referenzobjekt, z.B. eine Metallkugel oder eine Kreisscheibe verwendet, dessen Streuverhalten in Kopolarisation exakt bekannt ist. Anhand einer ersten Kalibrierung können dann weitere Referenzobjekte, z.B. zweiflächige Eckenreflektoren oder Zylinder begrenzter Länge, vermessen werden, wobei als Referenzwerte die mit dem ersten Referenzobjekt erhaltenen Kalibrierwerte herangezogen werden können.

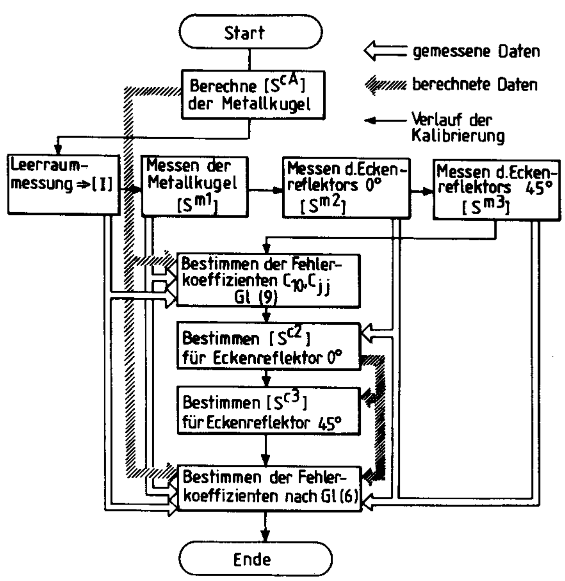


FIG. 3

EP 0 515 793 A2

Seit der Entdeckung der elektromagnetischen Wellen durch Heinrich Hertz im Jahre 1888 stellen Kalibrieren und Fehlerkorrektur von Radarund Antennenanordnungen bei Messungen der Ausbreitung von Wellen im freien Raum Probleme dar. Für lineare Polarisationen wurden für Antennen- und Radarquerschnittsmessungen, sog. RCS-Messungen (Radar Cross Section)) ausreichende Techniken entwickelt. Die Entwicklung der Polarimetrie brachte jedoch weitere Komplexität bei der Kalibrierung mit sich. Polarimetrische Messungen erfordern die Bestimmung von 12 Fehler- bzw. Korrekturkoeffizienten zur Fehlerkorrektur und zum Kalibrieren der Meßanordnung in Phase und Amplitude. Zur mathematischen Bestimmung der Korrekturkoeffizienten müssen drei Eichziele bzw. Referenzobjekte vermessen und eine sog. Leerraum-Messung, d.h. eine Messung ohne Reflexion der elektromagnetischen Wellen an einem Referenzobjekt, durchgeführt werden. Voraussetzung für die drei Referenzobjekte ist, daß deren, die Kreuzpolarisation definierenden Streukoeffizienten $\underline{S}_{vh}$ und $\underline{S}_{hv}$ gleich sind, wobei die Indizes v und h jeweils vertikal bzw. horizontal bedeuten. Als Referenzobjekte werden Metallkugeln, metallene Kreisscheiben, Zylinder und Eckenreflektoren vorgeschlagen. Eine typische Kalibrierung erfolgt z.B. folgendermaßen:

- zunächst werden die Streumatrizen aller drei Referenzobjekte errechnet, z.B. einer Kugelbzw. einer Kreisscheibe (1. Referenz) , eines zweiflächigen Eckenreflektors bzw. eines Metallzylinders in vertikaler Anordnung (2. Referenz) und in einer 45°-Stellung (3. Referenz)
- danach wird eine Leerraum-Messung vorgenommen, mit der vier Isolationskoeffizienten einer additiven Korrekturmatrix bestimmt werden, mit denen berücksichtigt wird, daß der leere Raum nicht reflektiert und theoretisch ein Null-Signal empfangen werden müßte;
- anschließend wird die Kugel bzw. die Kreisscheibe vermessen, dann erfolgt eine Messung mit dem vertikal angeordneten zweiflächigen Eckenreflektor oder dem ebenfalls vertikal angeordneten Metallzylinder und schließlich eine Messung mit dem um 45° geneigten Eckenreflektor oder Metallzylinder.
- Nach Abschluß dieser drei Messungen können die Korrekturkoeffizienten berechnet und die Meßanordnung für spätere Messungen kalibriert werden.

Schwierigkeiten liegen hierbei in der präzisen Berechnung der Streumatrizen der Referenzobjekte und bei der Positionierung dieser Referenzobjekte, die wegen der unterschiedlichen Phasenreferenzen sehr genau sein muß.

Der Erfindung liegt die Aufgabe zugrunde, ein Verfahren zum Kalibrieren von Radar- und Antennenanordnungen anzugeben, das mit weniger, jedoch präzisen Berechnungen und Messungen auskommt, wobei gleichzeitig die Genauigkeit der Kalibrierung verbessert werden soll.

Mit der Erfindung wird vorgeschlagen, zum Kalibrieren der Amplitude und Phase der Meßanordnung einzig und allein ein Referenzobjekt zu verwenden, das ausschließlich in Ko-Polarisation reflektiert, z.B. eine Metallkugel oder eine flache Metallscheibe, und dessen Reflexionsquerschnitt mit der erforderlichen Genauigkeit berechenbar ist. Aus dem Vergleich der exakten Berechnung und der mit Fehlern behafteten Messung werden die Korrekturkoeffizienten für nachfolgende Kalibrations-Messungen abgeleitet. Im übrigen sollte das Referenzobjekt hierbei im Wellenfeld der Meßanordnung an der Stelle positioniert werden, an der sich später ein zu vermessendes Meßobjekt befinden wird.

Für die weitere Kalibrierung der Meßanordnung zum Messen der Kreuz-Polarisation können dann Referenzobjekte verwendet werden, deren Ko- und Kreuzpolarisationsverhalten nur mehr qualitativ, jedoch nicht mehr quantitativ bekannt sein muß, da diese Objekte quantitativ in der Ko-Polarisation nach dem obigen Verfahren mit einem einzigen Referenzobjekt präzise vermessen werden. Hierfür geeignete Referenzobjekte sind z.B. metallene zweiflächige Eckenreflektoren oder gerade Metallzylinder.

Aus den durchgeführten Messungen an den Referenzobjekten können die Korrekturkoeffizienten zur vollständigen polarimetrischen Fehlerkorrektur bestimmt werden.

Die Erfindung ist anhand der Zeichnung näher erläutert. In dieser stellen dar:

| | |
|---|---|
| Fig. 1 | ein Blockdiagramm eines Systemes zur kohärenten polarimetrischen Radarquerschnittsmessung; |
| Fig.2a bis 2c | Darstellungen der für ein Kalibrierverfahren gemäß der Erfindung verwendeten Referenzobjekte; |
| Fig. 3 | ein Ablaufdiagramm eines Kalibrierverfahrens nach der Erfindung zum Kalibrieren einer Radaranordnung. |

Die folgenden Algorithmen sind für RCS-Messungen entwickelt, können jedoch ohne weiteres auf Antennenmessungen und andere Messungen im freien Raum angewandt werden.

Für eine bestimmte Frequenz und einen bestimmten Bestrahlungswinkel ist das Radarstreuverhalten eines Meßobjektes bestimmt durch die komplexe polarimetrische RCS-Matrix Sigma:

$$[\underline{\sigma}] = \begin{bmatrix} \underline{\sigma}_{hh} & \underline{\sigma}_{hv} \\ \underline{\sigma}_{vh} & \underline{\sigma}_{vv} \end{bmatrix} \qquad (1)$$

Hierbei und im folgenden werden orthogonale lineare Polarisationen in vertikaler (v) und horizontaler (h) Richtung als Basis herangezogen; komplexe Werte sind unterstrichen; die Ergebnisse gelten für alle orthogonalen Polarisationen.

Diese komplexe RCS-Matrix kann wegen Fehlern der Meßanordnung nicht direkt gemessen werden. Fehler sind insbesondere statistische Fehler, systematische lineare Fehler, die auf Synthesizern, Detektoren, Kabeln, Schaltern, Antennen, Kopplern, auf Polarisationskopplungen im Sende- und Empfangskanal oder Isolationsfehler durch Übersprechen zwischen Sende- und Empfangskanal etc. zurückzuführen sind, und systembedingte nichtlineare Fehler der Schaltungskomponenten der Meßanordnung.

Zur Kalibrierung wird zweckmäßigerweise von einer komplexen Polarisationsstreumatrix $[\underline{S}]$ ausgegangen, die mit der obigen RCS-Matrix wie folgt zusammenhängt:

$$[\underline{S}] = \frac{1}{\sqrt{4\pi R_0^2}} \cdot [\sqrt{\underline{\sigma}}] \qquad (2)$$

wobei $R_0$ einen festen Referenzradius des Meßobjektes darstellt.

In Fig. 1 kennzeichnet der Block 1 die Meßanordnung des Radarsystems, 4 das Meß- bzw. Referenzobjekt, mit 2 und 3 ist der Sende- bzw. Empfangspfad bezeichnet und mit 5 die Kopplung dieser beiden Pfade. Das Radargerät kann nur die ausgesendeten Wellen $\underline{a}_h$, $\underline{a}_v$ sowie die empfangenen Wellen $\underline{b}_h$, $\underline{b}_v$ messen. Die Streumatrix [S] verkoppelt diese Größen wie folgt:

$$\begin{bmatrix} \underline{b}_h \\ \underline{b}_v \end{bmatrix} = \begin{bmatrix} \underline{S}^m_{hh} & \underline{S}^m_{hv} \\ \underline{S}^m_{vh} & \underline{S}^m_{vv} \end{bmatrix} \begin{bmatrix} \underline{a}_h \\ \underline{a}_v \end{bmatrix} \qquad (3)$$

Das hochangestellte "m" bezeichnet hierbei "gemessene" Koeffizienten. Die oben aufgeführten Fehler entstehen in den Blöcken 2, 4 und 5 gemäß Fig. 1. Hierfür können ebenfalls Streumatrizen [T] für "Transmit", d.h. den Sendepfad [R] für "Receive", d.h. den Empfangspfad, und [I] für "Isolation", d.h. den Grad der Kopplung zwischen Sende- und Empfangspfad zugeordnet werden. Dies führt zu der Matrixgleichung

$$[\underline{S}^m] = [\underline{I}] + [\underline{R}] * [\underline{S}^c] * [\underline{T}] \qquad (4a)$$

in der das hochgestellte "c" auf die korrekte Streumatrix hindeutet. Ausgeschrieben lautet diese Gleichung:

$$\begin{bmatrix} \underline{S}^m_{hh} & \underline{S}^m_{hv} \\ \underline{S}^m_{vh} & \underline{S}^m_{vv} \end{bmatrix} = \begin{bmatrix} \underline{I}_{hh} & \underline{I}_{hv} \\ \underline{I}_{vh} & \underline{I}_{vv} \end{bmatrix} + \begin{bmatrix} \underline{R}_{hh} & \underline{R}_{hv} \\ \underline{R}_{vh} & \underline{R}_{vv} \end{bmatrix} \begin{bmatrix} \underline{S}^c_{hh} & \underline{S}^c_{hv} \\ \underline{S}^c_{vh} & \underline{S}^c_{vv} \end{bmatrix} \begin{bmatrix} \underline{T}_{hh} & \underline{T}_{hv} \\ \underline{T}_{vh} & \underline{T}_{vv} \end{bmatrix} \qquad (4b)$$

Ersichtlich hängt die korrekte Streumatrix von 12 Fehler- bzw. Korrekturkomponenten ab. Die korrekte

Matrix kann entsprechend durch Inversion der Gleichung (4b) bestimmt werden.

Die additive Matrix [I] kann durch eine Leerraum-Messung bestimmt werden, für die keine reflektierten Empfangssignale zu erwarten wären, d.h. die korrekte Streumatrix wird zu NULL gesetzt. Daraus folgt für diese Messung unmittelbar, daß die gemessene Streumatrix gleich der Isolationsmatrix ist.

Die acht verbleibenden Koeffizienten der Matrizen [R] und [T] könnten in herkömmlicher Weise durch Berechnen der Streumatrizen und Vermessen von drei Referenzobjekten bestimmt werden.

Es ist vorteilhaft, die Matrizen [R] und [T] zusammenzufassen, so daß daraus eine Korrekturmatrix [C] mit sechzehn Koeffizienten $c_{ij}$ entsteht und die additive Isolationsmatrix rechnerisch auf die Seite der Streumatrix zu bringen. Hiermit ergibt sich

$$[\underline{S}^m] - [\underline{I}] = [\underline{M}] = [\underline{C}] \cdot [\underline{S}^c] \qquad (5)$$

Ausgeschrieben lautet diese Matrix-Gleichung:

$$\begin{bmatrix} \underline{S}^m_{vv} \\ \underline{S}^m_{hh} \\ \underline{S}^m_{vh} \\ \underline{S}^m_{hv} \end{bmatrix} - \begin{bmatrix} \underline{c}_{10} \\ \underline{c}_{20} \\ \underline{c}_{30} \\ \underline{c}_{40} \end{bmatrix} = \begin{bmatrix} \underline{M}_{vv} \\ \underline{M}_{hh} \\ \underline{M}_{vh} \\ \underline{M}_{hv} \end{bmatrix} = \begin{bmatrix} \underline{c}_{11} & \underline{c}_{12} & \underline{c}_{13} & \underline{c}_{14} \\ \underline{c}_{21} & \underline{c}_{22} & \underline{c}_{23} & \underline{c}_{24} \\ \underline{c}_{31} & \underline{c}_{32} & \underline{c}_{33} & \underline{c}_{34} \\ \underline{c}_{41} & \underline{c}_{42} & \underline{c}_{43} & \underline{c}_{44} \end{bmatrix} \begin{bmatrix} \underline{S}^c_{vv} \\ \underline{S}^c_{hh} \\ \underline{S}^c_{vh} \\ \underline{S}^c_{hv} \end{bmatrix} \qquad (6)$$

Die additiven Koeffizienten $\underline{c}_{k0}$ entsprechen den Koeffizienten der Isolationsmatrix, die durch die obige Leerraum-Messung bestimmt wurden. Die 16 Koeffizienten $\underline{c}_{ij}$ resultieren aus der Multiplikation der Koeffizienten der Sende- und Empfangsmatrizen. Die Koeffizienten in der Diagonale mit den gleichen Indizes repräsentieren die Fehler der polarimetrischen Frequenzantwort des Systems. Die Koeffizienten $\underline{c}_{12}$, $\underline{c}_{21}$, $\underline{c}_{34}$ und $\underline{c}_{43}$ resultieren aus der Kreuzkopplung in den zwei orthogonalen polarisierten Kanälen. Die Korrekturmatrix [C] hat zwar 16 Koeffizienten, jedoch können diese wegen ihrer nichtlinearen Beziehung untereinander durch 8 Koeffizienten ausgedrückt werden. Hierzu sind mehrere Möglichkeiten vorhanden, eine vorteilhafte lautet folgendermaßen:

$$[\underline{C}] = \begin{bmatrix} \underline{c}_{11} & \frac{\underline{c}_{32} \cdot \underline{c}_{42}}{\underline{c}_{22}} & \frac{\underline{c}_{32} \cdot \underline{c}_{11}}{\underline{c}_{33}} & \frac{\underline{c}_{33} \cdot \underline{c}_{42}}{\underline{c}_{22}} \\ \frac{\underline{c}_{31} \cdot \underline{c}_{41}}{\underline{c}_{11}} & \underline{c}_{22} & \frac{\underline{c}_{33} \cdot \underline{c}_{41}}{\underline{c}_{11}} & \frac{\underline{c}_{31} \cdot \underline{c}_{22}}{\underline{c}_{33}} \\ \underline{c}_{31} & \underline{c}_{32} & \underline{c}_{33} & \frac{\underline{c}_{32} \cdot \underline{c}_{31}}{\underline{c}_{33}} \\ \underline{c}_{41} & \underline{c}_{42} & \frac{\underline{c}_{42} \cdot \underline{c}_{41}}{\underline{c}_{44}} & \underline{c}_{44} \end{bmatrix} \qquad (7)$$

Diese Gleichung (7) führt zu einem lösbaren Gleichungssystem mit acht Unbekannten, wobei theoretisch zur Lösung zwei Referenzobjekte mit jeweils vier linear unabhängigen Streukoeffizienten ausreichend wären. Solche Referenzobjekte sind jedoch nicht bekannt, so daß herkömmlich - wie oben ausgeführt - die Korrekturkoeffizienten durch Vermessen dreier Referenzobjekte bestimmt werden, die die korrekten, d.h.

berechneten Streumatrizen $[S^{c1}]$, $[S^{c2}]$ und $[S^{c3}]$ mit jeweils gleichen Kreuzpolarisationskoeffizienten $\underline{S}_{vh} = \underline{S}_{hv}$ haben.

Die Erfindung geht nun einen anderen Weg.

Zunächst wird angenommen, daß lediglich Objekte vermessen werden, für die die Kreuzpolarisation vernachlässigbar ist, z.B. Metallkugeln oder flache Metallscheiben. Deren Streumatrix hat die Form:

$$[\underline{S}] = \begin{bmatrix} \underline{a} & 0 \\ 0 & \underline{b} \end{bmatrix} \quad \text{mit } |\underline{a}| \approx |\underline{b}| \qquad (8)$$

Mit dieser Annahme kann die obige Gleichung (6) vereinfacht werden zu:

$$\begin{bmatrix} \underline{S}^m_{hh} \\ \underline{S}^m_{vv} \end{bmatrix} = \begin{bmatrix} \underline{c}_{10} \\ \underline{c}_{20} \end{bmatrix} + \begin{bmatrix} \underline{c}'_{11} & 0 \\ 0 & \underline{c}'_{22} \end{bmatrix} \cdot \begin{bmatrix} \underline{S}^c_{hh} \\ \underline{S}^c_{vv} \end{bmatrix} \qquad (9)$$

Die verbleibenden vier Fehler- bzw. Korrekturkoeffizienten können durch Vermessung lediglich eines einzigen bekannten Referenzobjektes und durch eine Leerraummessung bestimmt werden. (Eine derartige Kalibrierung wird R + I-Kalibrierung (Response + Isolation) genannt. Als Referenzobjekt ist eine Metallkugel gut geeignet (Fig. 2a), da deren Streumatrix, ausgehend von der komplexen RCS-Matrix, exakt bekannt ist. Diese lautet:

$$[\underline{\sigma}] = \begin{bmatrix} \underline{\sigma}_{hh} & 0 \\ 0 & \underline{\sigma}_{vv} \end{bmatrix} \qquad \text{mit } \underline{\sigma}_{hh} = \underline{\sigma}_{vv} \qquad (10)$$

Der Fehler, der durch Polarisationskopplung induziert wird, wird in diesem Falle nicht berücksichtigt und ist kleiner als 0,05 dB, wenn die Ko-Polarisationskoeffizienten $\underline{S}_{vv}$, $\underline{S}_{hh}$ annähernd gleich sind. Eine Kugel kann mit so geringen Toleranzen gefertigt werden, daß diese Bedingung immer eingehalten wird.

Berechnungen der Streumatrix der Kugel sind vielfach publiziert worden; so z.B. auch in dem Aufsatz von T.B.A. Senior, "Scattering by a sphere", Proceedings of the IEE, Vol. 111, No. 5, S. 907-916, 1964.

Als zweites Referenzobjekt ist ein zweiflächiger Eckenreflektor empfehlenswert, da dieser für einen Winkel von 45° gegen die horizontale und vertikale Achse (vgl. Fig. 2c) die einfallenden Wellen vollständig kreuzpolarisiert. Für einen Winkel von 0°, vgl. die Fig. 2a, hat die Streumatrix eines zweiflächigen Eckenreflektors die Form:

$$[\underline{S}] = \begin{bmatrix} \underline{a} & 0 \\ 0 & -\underline{a} \end{bmatrix} \qquad (11)$$

Es ist ersichtlich, daß die Kreuzpolarisation bei dieser Stellung NULL ist. Somit haben die Streumatrizen der Kugel entsprechend den Gleichungen (8) bzw. (10) und die des zweiflächigen Eckenreflektors entsprechend der obigen Gleichung die gleiche Form, die durch die obige Gleichung (8) vorgegeben ist. Aus diesem Grund kann die Streumatrix des zweiflächigen Eckenreflektors in der Position gemäß Fig. 2a mit der Kante der Ecke in Vertikalrichtung vermessen werden, wobei dann die R + I-Kalibrierung mit der Metallkugel als Referenzobjekt und entsprechender Inversion der Gleichung (9) angewendet wird. Ergebnis ist die fehlerkorrigierte Streumatrix $[\underline{S}^{c2}]$ für den zweiflächigen Eckenreflektor in der Position gemäß Fig. 2b, ohne daß hierzu das theoretische Streuverhalten dieses Referenzobjektes berechnet werden mußte. Aus

dieser Streumatrix kann dann die für die vollständige Kalibrierung erforderliche dritte korrekte Streumatrix [$\underline{S}^{c3}$] berechnet werden, und zwar wiederum für den zweiflächigen Eckenreflektor in einer Stellung gemäß Fig. 2c, in der die Richtung der Eckenkante gegenüber der vertikalen und der horizontalen Achse einen Winkel von jeweils 45° einnimmt. Diese Streumatrix [$\underline{S}^{c3}$] kann mit Hilfe einer Basistransformation entsprechend folgender Gleichung berechnet werden:

$$\left[\underline{S}^{c3}\right] = [R]^{-1} \cdot \left[\underline{S}^{c2}\right] \cdot [R] \quad \text{mit} \quad [R] = \begin{bmatrix} \cos\vartheta & -\sin\vartheta \\ \sin\vartheta & \cos\vartheta \end{bmatrix} \qquad (12)$$

Somit sind alle drei für eine vollständige Kalibrierung notwendigen Streumatrizen durch die Kenntnis des Streuverhaltens lediglich eines einzigen Referenzobjektes bestimmt worden, und zwar mit einer Präzision von besser als 0,05 dB.

Mit den beschriebenen Referenzobjekten kann die Kalibrierung wie oben anhand der Gleichungen (1) bis (7) durchgeführt werden. Der Vorteil einer derartigen Kalibrierung ist in dem Flußdiagramm der Fig. 3 gezeigt, in dem die unterschiedlichen Pfeilarten die gemessenen Daten, die berechneten Daten sowie einen möglichen Verlauf der Kalibrierung darstellen.

Nach dem Start der Kalibrierung wird in einem ersten Schritt die Streumatrix [$\underline{S}^{c1}$] des ersten Referenzobjektes, in diesem Fall der Metallkugel , berechnet. Die sich daran anschließenden Messungen sind die gleichen, die auch bei einer herkömmlichen Kalibrierung verwendet werden. Nach einer Leerraummessung und Bestimmen der Streumatrix [$\underline{S}^{ml}$] durch Vermessen der Metallkugel mit Hilfe einer R + I-Kalibrierung können die Koeffizienten der Gleichung (9) bestimmt werden. Aus der Vermessung des zweiten Referenzobjektes, d.h. des zweiflächigen Eckenreflektors in der 0°-Stellung gemäß Fig. 2b folgt dann unmittelbar die korrekte Streumatrix [$\underline{S}^{c2}$]. Die Transformation entsprechend Gleichung (12), angewandt auf diese Streumatrix [$\underline{S}^{c2}$], ergibt unmittelbar die fehlerkorrigierte dritte Streumatrix [$\underline{S}^{c3}$] für den zweiflächigen Eckenreflektor in einer 45°-Stellung entsprechend Fig. 2c.

Nachdem sämtliche Referenzmatrizen bekannt sind, können auch die oben erwähnten zwölf Fehler- bzw. Korrekturkoeffizienten berechnet und die Kalibrierung beendet werden.

Anstatt einer Metallkugel kann als Referenzobjekt auch eine sehr dünne Metallscheibe verwendet werden, deren Streumatrix formmäßig gleich derjenigen der Metallkugel ist. Hier muß die Bestrahlungsgeometrie jedoch so eingestellt werden, daß möglichst wenig Streuprobleme an den Ecken der Metallscheibe auftreten. Ansonsten sind jedoch die Streumatrizen für Metallscheiben exakt bekannt. Als zweites Referenzobjekt könnte anstatt des Eckenreflektors z.B. ein Zylinder mit begrenzter Länge verwendet werden, und zwar in einer ersten Stellung, in der die Zylinderachse in der Vertikalen liegt und in einer zweiten Stellung, in der die Achse gegenüber der Vertikalen und der Horizontalen um 45° geneigt ist. Auch für dieses Referenzobjekt ist das Streuverhalten qualitativ bekannt, so daß die obige Kalibrierung ebenfalls durchgeführt werden kann.

Der kritischste Punkt bei einer Kalibrierung mit Hilfe zunächst nur eines Referenzobjektes ist der Fehler in der Ausrichtung zwischen den Messungen des zweiten und dritten Referenzobjektes, in diesem Fall der Ausrichtung des zweiflächigen Eckenreflektors zwischen der 0°- und der 45°-Stellung. Der Ausrichtfehler ist hierbei die Abweichung von 45°. Es konnte jedoch gezeigt werden, daß diese Ausrichtung nur geringen Einfluß auf die Endergebnisse hat: So ist z.B. für eine Fehlausrichtung von 5° der relative Fehler der Kreuzpolarisationskoeffizienten etwa 1,5 %.

Die vorgeschlagene Kalibrierung mit Hilfe zunächst nur eines einzigen Referenzobjektes ermöglicht eine Kalibrierung hinsichtlich der Amplituden mit einer Genauigkeit von < 0,3 dB, der Phase mit einer Genauigkeit von < 2° und der Bestimmung der Kreuzpolarisation mit > 55 dB. Diese Werte können über mehrere Oktaven der Meßfrequenz eingehalten werden. Die Kreuzpolarisation kann mit mehr als 30 dB besser als bei herkömmlichen Kalibrierungsverfahren bestimmt werden. Das Verfahren gemäß der Erfindung ermöglicht eine dynamische Kalibrierung, die zeit- und temperaturstabil ist. Mit dem angegebenen Kalibrierverfahren wird eine bisher nicht erreichte Genauigkeit in Ko- und Kreuz-Polarisationsmessungen möglich. Neben der RCS-Messung können andere polarimetrische Messungen im freien Raum, wie Antennenvermessungen oder Kompatibilitätsmessungen mit Hilfe der vorgeschlagenen Kalibrierung mit lediglich einem Referenzobjekt verbessert werden.

**Patentansprüche**

1. Verfahren zum Kalibrieren von Radar- und Antennenanordnungen zur Durchführung von komplexen, polarimetrischen Antennen- und Reflexionsquerschnittsmessungen, wobei Referenzobjekte vermessen werden und anhand der Meßwerte unter Anwendung von für die Reflexionsquerschnitte abgeleiteten Gleichungen die Meßanordnung hinsichtlich Amplitude , Phase und Polarisation kalibriert wird, dadurch gekennzeichnet, daß zunächst ein einziges Referenzobjekt für die Kalibrierung verwendet wird, welches ausschließlich in Kopolarisation reflektiert und dessen Reflexionsquerschnitt bekannt bzw. berechenbar ist.

2. Verfahren nach Anspruch 1, dadurch gekennzeichnet, daß als Referenzobjekt eine Metallkugel bzw. eine metallene Kreisscheibe verwendet wird, die im Wellenfeld der Meßanordnung an der Stelle positioniert sind, an der sich für anschließende Messungen später ein Meßobjekt befinden wird.

3. Verfahren nach Anspruch 1 oder 2, dadurch gekennzeichnet, daß zur Kalibrierung der komplexe Reflexionsquerschnitt des Referenzobjektes gemessen und berechnet wird, und daß aus dem Vergleich der berechneten Werte und der mit Fehlern behafteten Meßwerte Korrekturkoeffizienten für die folgenden Messungen abgeleitet werden.

4. Verfahren nach einem der vorhergehenden Ansprüche, dadurch gekennzeichnet, daß für eine weitere Kalibrierung zum Messen der Kreuzpolarisation von Meßobjekten weitere Referenzobjekte verwendet werden, deren Ko- und Kreuzpolarisationsverhalten nur mehr qualitativ, jedoch nicht mehr quantitativ bekannt sein muß, wobei als Referenz die mit dem ersten, nur in Kopolarisation streuenden Referenzobjekt bestimmten Kalibrierwerte verwendet werden.

5. Verfahren nach Anspruch 4, dadurch gekennzeichnet, daß als zweites und drittes Referenzobjekt ein zweiflächiger Eckenreflektor bzw. ein Metallzylinder begrenzter Länge jeweils in einer vertikal ausgerichteten 0°-Stellung und einer gegenüber der Vertikalen und Horizontalen geneigten 45°-Stellung verwendet werden.

6. Verfahren nach einem der Ansprüche 1 bis 5, dadurch **gekennzeichnet**, daß aus den durchgeführten Messungen und Berechnungen an den Referenzobjekten die KorrekturKoeffizienten zur vollständigen polarimetrischen Fehlerkorrektur abgeleitet werden.

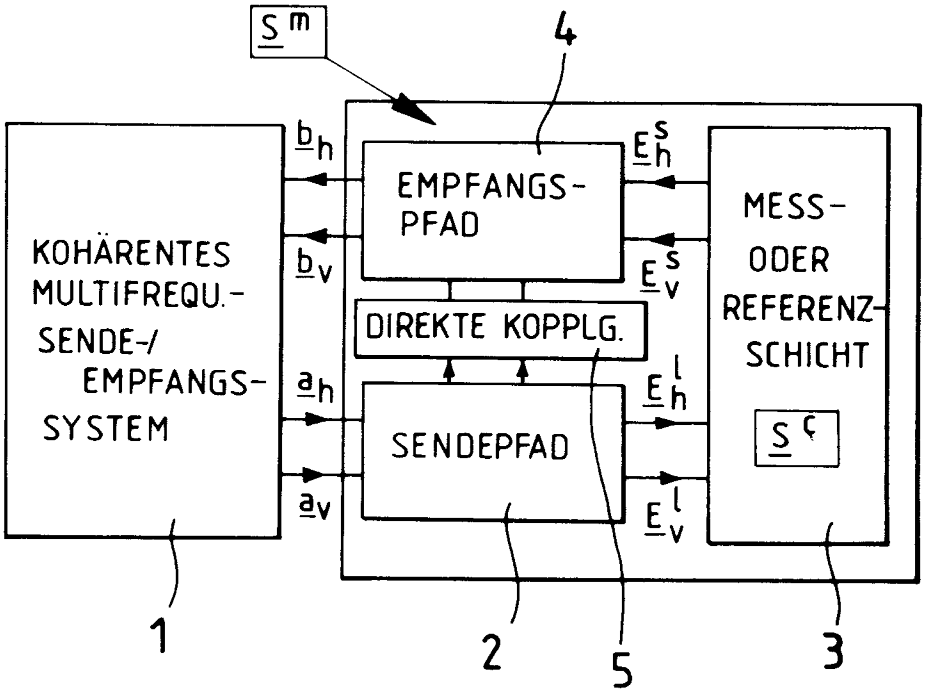


FIG. 1

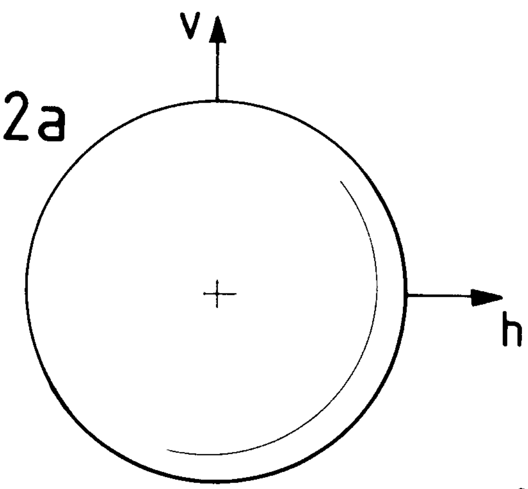


FIG.2a

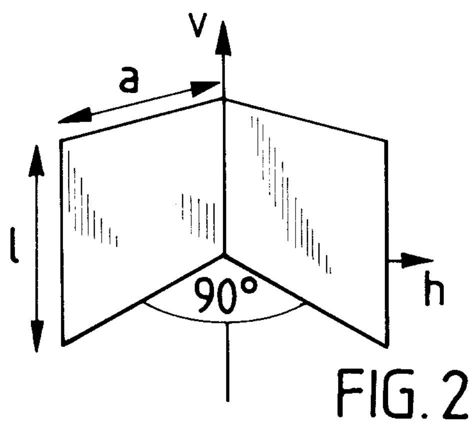


FIG. 2b

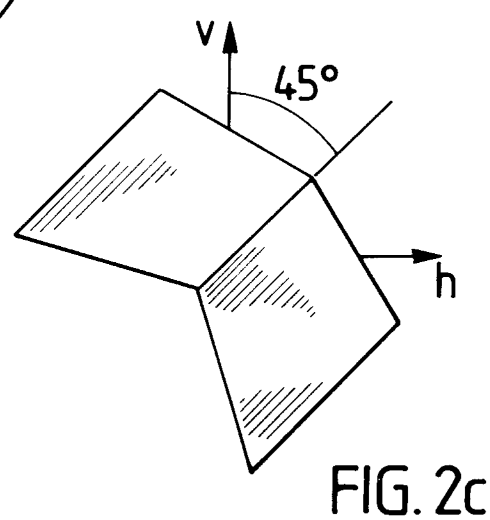


FIG. 2c

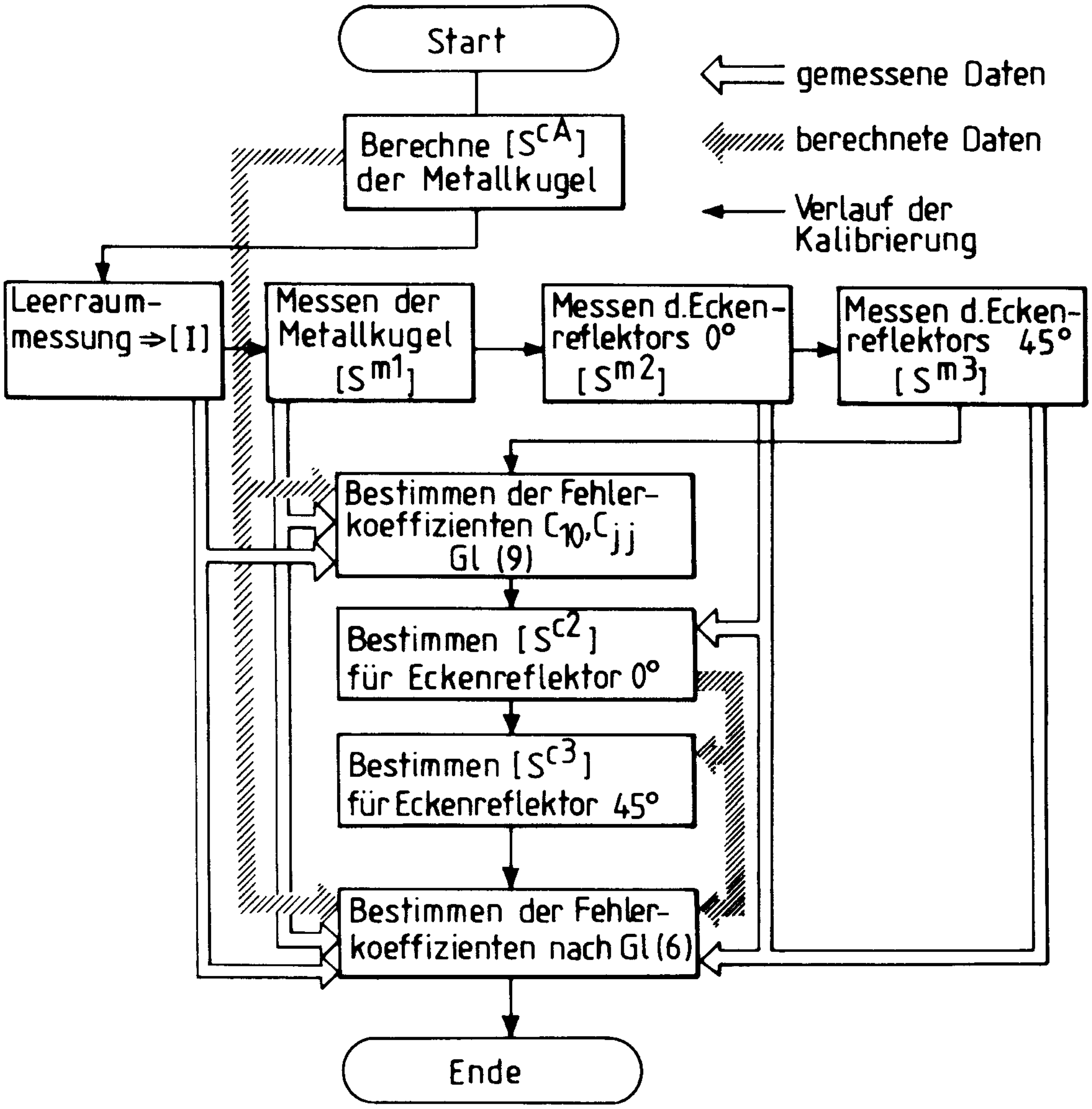
Start
gemessene Daten
berechnete Daten
Verlauf der Kalibrierung
Berechne [S^cA] der Metallkugel
Leerraum-messung ⇒ [I]
Messen der Metallkugel [S^m1]
Messen d. Eckenreflektors 0° [S^m2]
Messen d. Eckenreflektors 45° [S^m3]
Bestimmen der Fehlerkoeffizienten C10, Cjj Gl (9)
Bestimmen [S^c2] für Eckenreflektor 0°
Bestimmen [S^c3] für Eckenreflektor 45°
Bestimmen der Fehlerkoeffizienten nach Gl (6)
Ende

FIG. 3